## Europäisches Patentamt

## European Patent Office

## Office européen des brevets

(19)

(11) Veröffentlichungsnummer : **0 066 334**
**B1**

(12)

# EUROPÄISCHE PATENTSCHRIFT

(45) Veröffentlichungstag der Patentschrift :
26.03.86

(21) Anmeldenummer : **82200617.7**

(22) Anmeldetag : **19.05.82**

(51) Int. Cl.⁴ : **H 01 L 23/56**, H 03 L   1/00,
H 03 F   1/14

(54) Schaltungsanordnung mit einer integrierten Halbleiterschaltung.

(30) Priorität : **30.05.81 DE 3121671**

(43) Veröffentlichungstag der Anmeldung :
**08.12.82 Patentblatt 82/49**

(45) Bekanntmachung des Hinweises auf die Patenterteilung : **26.03.86 Patentblatt 86/13**

(84) Benannte Vertragsstaaten :
**DE FR GB IT**

(56) Entgegenhaltungen :
**GB-A- 1 241 285**
**US-A- 3 325 700**
**EDN THE ELECTRONIC ENGINEER'S DESIGN MAGAZINE, Band 11, Nr. 8, Juli 1966, Seiten 70-77, Denver (USA); DEBOO et al.: "MOS-Bipolars — The solution to your input problems"**
**PATENTS ABSTRACTS OF JAPAN, Band 5, Nr. 70(E-56) 742, 12. Mai 1981;**
**IEEE JOURNAL OF SOLID-STATE CIRCUITS, Band SC-3, Nr. 4, Dezember 1968, Seiten 401-407, New York (USA); MATAYA et al.: "IF amplifier using Cc compensated transistors"**

(73) Patentinhaber : **Philips Patentverwaltung GmbH Billstrasse 80**
**D-2000 Hamburg 28 (DE)**
**DE**
**N.V. Philips' Gloeilampenfabrieken Groenewoudseweg 1**
**NL-5621 BA Eindhoven (NL)**
**FR GB IT**

(72) Erfinder : **Kohsiek, Cord Heinrich**
**Hamburger Weg 10**
**D-2086 Ellerau (DE)**

(74) Vertreter : **David, Günther M. et al**
**Philips Patentverwaltung GmbH Billstrasse 80 Postfach 10 51 49**
**D-2000 Hamburg 28 (DE)**

EP 0 066 334 B1

**0 066 334**

**Beschreibung**

Die Erfindung betrifft eine Schaltungsanordnung mit einer integrierten Halbleiterschaltung mit einer Umhüllung mit mehreren Anschlußleitern, bei der zwischen einem ersten Anschlußleiter und den beiden, ihm benachbarten zweiten und dritten Anschlußleitern parasitäre Kapazitäten mit gleichem Temperaturkoeffizienten bestehen.

Bei einer integrierten Halbleiterschaltung, die üblicherweise in einem sog. « dual in-line »-Gehäuse angeordnet ist, treten zwischen den benachbarten Anschlußleitern parasitäre Kapazitäten auf.

In vielen Fällen ist es aber wünschenswert, zwischen den Anschlußleitern einer solchen integrierten Halbleiterschaltung eine möglichst kleine Kapazität oder eine möglichst kleine Temperaturabhängigkeit dieser parasitären Kapazität zu haben. Dies ist insbesondere wichtig für hochohmige, signalverarbeitende Schaltungen, Schwingkreise, Oszillatoren etc.

Man kann versuchen, den Temperaturkoeffizienten der störenden parasitären Kapazität dadurch zu kompensieren, daß die integrierte Halbleiterschaltung extern mit einer Kapazität mit einem entgegengesetzten Temperaturkoeffizienten beschaltet wird. Dadurch wird jedoch die Gesamtkapazität erhöht und der Anwendungsbereich der Halbleiterschaltung in vielen Fällen unzulässig eingeengt.

Aus der GB-PS 12 41 285 ist es bekannt, die störende Basis-Kollektor-Kapazität eines Transistors in einem Transistorverstärker durch eine zusätzliche, in den Halbleiterkörper des Transistors mit integrierte Kapazität zu neutralisieren. Auf diese Weise ist es jedoch nicht möglich, die parasitären Kapazitäten zwischen den Anschlußleitern einer integrierten Halbleiterschaltung zu kompensieren.

Der Erfindung liegt nun die Aufgabe zugrunde, eine Schaltungsanordnung der eingangs genannten Art so auszugestalten, daß die parasitäre Kapazität zwischen einem ersten und einem zweiten Anschlußleiter auf einfache Weise so kompensiert wird, daß der Temperaturkoeffizient dieser parasitären Kapazität keinen Einfluß mehr auf die aus der integrierten Halbleiterschaltung und ihrer äußeren Beschaltung gebildete Gesamtschaltung hat.

Diese Aufgabe wird erfindungsgemäß dadurch gelöst, daß zwischen dem ersten und dem dritten Anschlußleiter eine Kompensationsspannung angelegt ist, die einen Strom durch die parasitäre Kapazität zwischen dem ersten und dem dritten Anschlußleiter zur Folge hat, der dem Strom durch die parasitäre Kapazität zwischen dem ersten und dem zweiten Anschlußleiter entgegengesetzt gleich ist.

Gemäß einer Weiterbildung der Erfindung wird die Kompensationsspannung von einer Schaltung erzeugt, die in die Halbleiterschaltung mit integriert ist.

Andere Weiterbildungen der Erfindung ergeben sich aus den Unteransprüchen.

Die mit der Erfindung erzielten Vorteile sind insbesondere darin zu sehen, daß sich die Kapazität zwischen zwei Anschlußleitern einer integrierten Halbleiterschaltung in einer Schaltungsanordnung sehr gut und ohne großen Aufwand kompensieren läßt. Darüberhinaus lassen sich auch ohne zusätzlichen Aufwand die entsprechenden parasitären Kapazitäten einer Fassung für die integrierte Halbleiterschaltung und die parasitären Kapazitäten zwischen den Zuleitungen zu den gen. Anschlußleitern auf einer, die integrierte Halbleiterschaltung tragenden Printplatte kompensieren.

Ausführungsbeispiele der Erfindung werden im folgenden anhand der beigefügten Zeichnungen näher erläutert.

Es zeigen :

Figur 1 eine integrierte Halbleiterschaltung mit ihren, parasitäre Kapazitäten bildenden Anschlußleitern,

Figur 2 das Ersatzschaltbild eines, parasitäre Kapazitäten bildenden Teils der integrierten Schaltung nach Fig. 1,

Figur 3 das Teil-Ersatzschaltbild der parasitären Kapazitäten einer, über eine Fassung in eine Printplatte eingesetzten integrierten Halbleiterschaltung, und

Figur 4 das Ersatzschaltbild einer Schaltungsanordnung mit einer integrierten Halbleiterschaltung, in der eine Oszillatorschaltung und eine Schaltung zur Erzeugung einer Kompensationsspannung integriert sind.

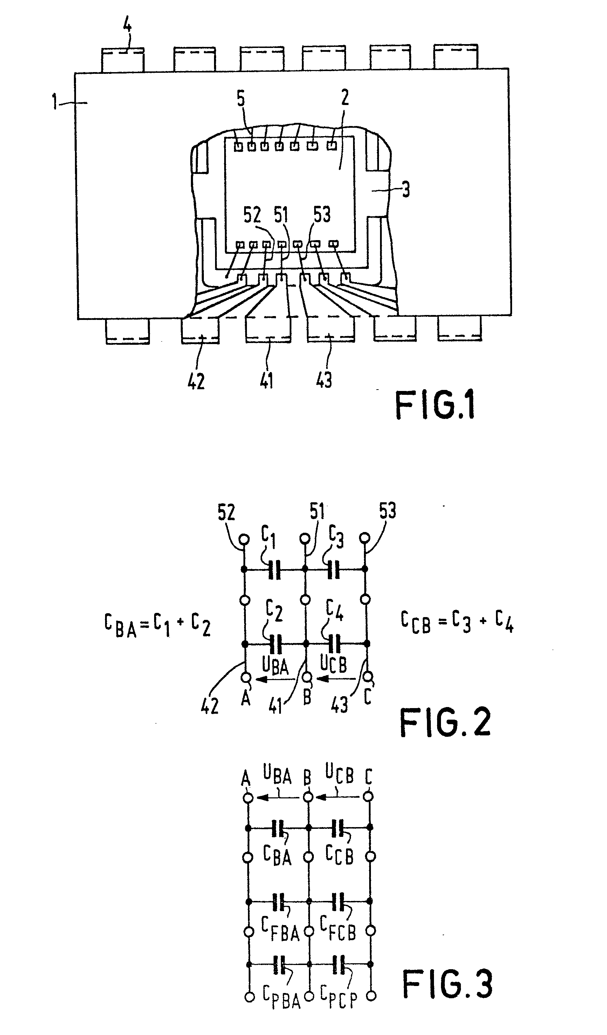

Fig. 1 zeigt eine integrierte Halbleiterschaltung, bei der ein Halbleiterkörper 2 in einer Umhüllung 1 auf einem Träger 3 montiert und über Bond-Drähte 5 mit den Anschlußbeinen 4 der integrierten Schaltung verbunden.

Von den Bond-Drähten 5 und den Anschlußbeinen 4, die zusammen die Anschlußleiter bilden, sind jeweils drei, d. h. die Bond-Drähte 51, 52 und 53, sowie die Anschlußbeine 41, 42 und 43, näher dargestellt.

Zwischen diesen nebeneinanderliegenden Anschlußleitern bilden sich parasitäre Kapazitäten aus, deren Ersatzschaltbild in Fig. 2 dargestellt ist. Der Anschlußleiter A wird dabei durch den Bond-Draht 52 und das Anschlußbein 42, der Anschlußleiter B durch den Bond-Draht 51 und das Anschlußbein 41 und der Anschlußleiter C durch den Bond-Draht 53 und das Anschlußbein 43 gebildet. Die sich zwischen den Bond-Drähten 51 und 52 einerseits und 51 und 53 andererseits ausbildenden parasitären Kapazitäten sind mit $C_1$ bzw. $C_3$ und die sich zwischen den Anschlußbeinen 41 und 42 einerseits und 41 und 43 andererseits ausbildenden parasitären Kapazitäten mit $C_2$ bzw. $C_4$ bezeichnet.

Zwischen den Anschlußleitern B und A liegt somit eine parasitäre Kapazität $C_{BA} = C_1 + C_2$ und zwischen den Anschlußleitern B und C eine parasitäre Kapazität $C_{CB} = C_3 + C_4$.

2

Es sei nun B der Anschlußleiter, dessen parasitäre Kapazität zu den benachbarten Anschlußleitern A und C, d. h. die parasitären Kapazitäten $C_{BA}$ und $C_{CB}$ die Funktion einer, die integrierte Schaltung enthaltenden Schaltungsanordnung beeinträchtigt. Die Wechselspannung zwischen den Anschlußleitern B und A sei

$$U_{BA} = U_0 \sin \omega t \,.$$

Dann fließt durch die parasitäre Kapazität $C_{BA}$ der Strom

$$I_{BA} = j\omega C_{BA}\, U_0 \sin \omega t \,.$$

Ein entsprechender Strom fließt durch die parasitäre Kapazität $C_{CB}$. Damit nun am Anschlußleiter B kein kapazitiver Strom wirksam wird, müssen die einander entgegengerichteten Ströme $I_{BA}$ und $I_{CB}$ gleich groß sein, d. h. beide Ströme müssen die gleiche Frequenz, gleiche Amplitude und gleiche Phasenlage, haben.

Diese Bedingung wird erfüllt, wenn dem Anschlußleiter C die Spannung

$$U_{CB} = U_0 \frac{C_{BA}}{C_{CB}} \sin \omega t = U_{BA} \frac{C_{BA}}{C_{CB}}$$

zugeführt wird.

Da alle parasitären Kapazitäten das gleiche Dielektrikum haben, das durch die Materialien der Umhüllung der integrierten Schaltung bestimmt ist, hat der Quotient

$$\frac{C_{BA}}{C_{CB}} = K$$

keine Temperaturabhängigkeit. Um also die richtige Kompensationsspannung $U_{CB}$ erzeugen zu können, genügt die Kenntnis von $U_{BA}$ und des Wertes von K. Dieser Quotient K ist nun aber durch die geometrischen Abmessungen der integrierten Schaltung, d. h. die Geometrie der Anschlußbeine und der Bond-Drähte, festgelegt.

Um die genannte Bedingung zu erfüllen, d. h. die parasitären Kapazitäten unwirksam zu machen, braucht also lediglich die Spannung $U_{CB} = K \cdot U_{BA}$ durch eine geeignete Schaltung erzeugt und dem Anschlußleiter C zugeführt werden.

Durch geeignete Wahl ihres Verhältnisses ist es auch möglich, weitere parasitäre Kapazitäten unwirksam zu machen, die in weiteren Teilen der Schaltungsanordnung gebildet sind, die mit dem ersten, dem zweiten und dem dritten Anschlußleiter verbunden sind.

Solche weiteren parasitären Kapazitäten sind z. B. die Kapazitäten in einer Fassung für die integrierte Schaltung und die Kapazitäten zwischen den Leitungsbahnen einer Printplatte, die mit den gen. Anschlußleitern verbunden sind.

In Fig. 3 ist das Teil-Ersatzschaltbild der parasitären Kapazitäten einer über eine Fassung in eine Printplatte eingesetzten integrierten Halbleiterschaltung dargestellt.

Um die parasitären Kapazitäten einer Fassung für die integrierte Halbleiterschaltung zu kompensieren, wird der Quotient

$$\left( \frac{C_{FBA}}{C_{FCB}} \right)$$

zwischen den parasitären Kapazitäten der Fassung zwischen dem ersten B und dem zweiten A Anschlußleiter und der parasitären Kapazität der Fassung zwischen dem ersten B und dem dritten C Anschlußleiter so gewählt, daß er ebenfalls den Wert K hat. Ist der Wert K der Fassung vorgegeben und kann nicht verändert werden, so kann der Wert K des Gehäuses der integrierten Schaltung entsprechend gewählt werden. Um auch die parasitäre Kapazität einer Printplatte, in die die integrierte Halbleiterschaltung eingesetzt ist, zu kompensieren, werden die Abmessungen der Leiterbahnen auf dieser Printplatte, die zu den gen. Anschlußleitern führen, so gewählt, daß der Quotient

$$\left( \frac{C_{PBA}}{C_{PCB}} \right)$$

der gegenseitigen Kapazität $C_{FBA}$ der Leiterbahnen der Printplatte, die mit dem ersten B und dem zweiten A Anschlußleiter verbunden sind, und der gegenseitigen Kapazität $C_{FCB}$ der Leiterbahnen der Printplatte, die mit dem ersten B und dem dritten C Anschlußleiter der Printplatte verbunden sind, ebenfalls den Wert K hat.

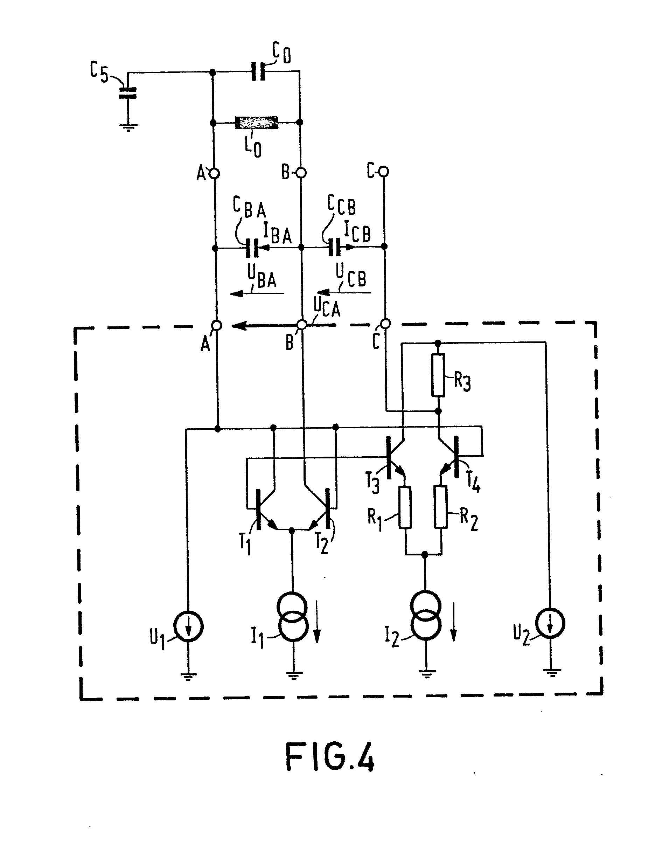

Die Fig. 4 zeigt schließlich ein Ausführungsbeispiel einer Schaltungsanordnung nach der Erfindung, bei dem in der integrierten Schaltung ein im wesentlichen aus den Transistoren $T_1$ und $T_2$, sowie der Spannungsquelle $U_1$ und der Stromquelle $I_1$ bestehender LC-Oszillator integriert ist, dessen frequenzbestimmende Elemente $C_0$ und $L_0$ jedoch als externe Bauelemente an die Anschlußleiter A und B angeschlossen sind. Der Anschlußleiter A ist weiter über eine Kapazität $C_5$ mit Masse verbunden, so daß die Oszillatorspannung nur am Anschlußleiter B liegt.

Bei dieser Schaltungsanordnung liegt nun parallel zu der frequenzbestimmenden Kapazität $C_0$ die parasitäre Kapazität $C_{BA}$, deren Temperaturkoeffizient zu einer Temperaturabhängigkeit der Oszillatorfrequenz führt.

Diese parasitäre Kapazität wird nun auf die beschriebene Weise dadurch kompensiert, daß dem dritten Anschlußleiter C eine Spannung $U_{CB}$ zugeführt wird, deren Amplitude gleich $K \cdot U_{BA}$ gewählt ist, wobei K der Quotient

$$\left(\frac{C_{BA}}{C_{CB}}\right)$$

der parasitären Kapazitäten zwischen dem ersten und dem zweiten bzw. dem ersten und dem dritten Anschlußleiter und $U_{BA} = U_0 \sin\omega t$ die am Ausgang des integrierten Teils der Oszillatorschaltung zwischen dem ersten und dem zweiten Anschlußleiter liegende Spannung ist.

Für die Ströme durch die parasitären Kapazitäten $C_{BA}$ und $C_{CB}$ gilt dann:

$$I_{BA} = U_{BA} \cdot j\omega C_{BA}$$

und

$$I_{CB} = U_{CB} \cdot j\omega C_{CB} \cdot$$

Mit

$$K = \frac{C_{BA}}{C_{CB}}$$

ergibt sich dann

$$U_{CB} = K \cdot U_{BA}$$

und

$$U_{CB} \cdot C_{CB} = U_{BA} \cdot C_{BA} \cdot$$

Damit werden die Ströme $I_{BA}$ und $I_{CB}$ gleich groß und am Anschlußleiter B entgegengesetzt gerichtet, so daß dort kein Strom auftritt, der durch die Kapazitäten $C_{BA}$ bzw. $C_{CB}$ verursacht ist und mit diesem temperaturabhängig ist. Die Oszillatorfrequenz wird somit lediglich durch $C_0$ und $L_0$ bestimmt und ist von den parasitären Kapazitäten unabhängig.

Die Kompensationsspannung $U_{CB}$ wird durch eine Hilfsschaltung erzeugt, die mit in die integrierte Schaltung integriert ist, und die im wesentlichen durch die Transistoren $T_3$ und $T_4$, die Widerstände $R_1$ bis $R_3$, den Spannungsgenerator $U_2$ und den Stromgenerator $I_2$ gebildet wird. Diese Schaltung bildet im wesentlichen einen Spannungsverstärker, der die Ausgangsspannung $U_{BA}$ der Oszillatorspannung die an der Basis des Transistors $T_3$ liegt, verstärkt und dem Anschlußleiter C zuführt.

**Patentansprüche**

1. Schaltungsanordnung mit einer integrierten Halbleiterschaltung in einer Umhüllung mit mehreren Anschlußleitern, bei der zwischen jeweils einem Anschlußleiter und den beiden, ihm benachbarten zweiten und dritten Anschlußleitern parasitäre Kapazitäten mit gleichen Temperaturkoeffizienten bestehen und bei der zwischen dem ersten und dem zweiten Anschlußleiter eine Spannung liegt, die einen Strom durch die parasitäre Kapazität zwischen diesen Anschlußleitern zur Folge hat, dadurch gekennzeichnet, daß zwischen dem ersten (B) und dem dritten Anschlußleiter (C) eine Kompensationsspannung angelegt ist, die einen Strom durch die parasitäre Kapazität zwischen dem ersten (B) und dem dritten Anschlußleiter (C) zur Folge hat, der dem Strom durch die parasitäre Kapazität zwischen dem ersten (B) und dem zweiten Anschlußleiter (A) entgegengesetzt gleich ist.

2. Schaltungsanordnung nach Anspruch 1, dadurch gekennzeichnet, daß die Kompensationsspannung von einer Schaltung erzeugt ist, die in die Halbleiterschaltung mit integriert ist.

3. Schaltungsanordnung nach Anspruch 1 oder 2, dadurch gekennzeichnet, daß die Amplitude der Kompensationsspannung ($U_{CB}$) das K-fache der Amplitude der zwischen dem ersten (B) und dem zweiten (A) Anschlußleiter liegenden Spannung ($U_{BA}$) beträgt, wobei K der Wert des Quotienten

$$\left(\frac{C_{BA}}{C_{CB}}\right)$$

der parasitären Kapazität ($C_{BA}$) zwischen dem ersten (B) und dem zweiten (A) Anschlußleiter und der parasitären Kapazität ($C_{CB}$) zwischen dem ersten (B) und dem dritten (C) Anschlußleiter ist.

4. Schaltungsanordnung nach Anspruch 3, mit einer Fassung für die integrierte Halbleiterschaltung, dadurch gekennzeichnet, daß der Quotient

$$\left(\frac{C_{FBA}}{C_{FCB}}\right)$$

der parasitären Kapazität der Fassung zwischen dem ersten (B) und dem zweiten (A) Anschlußleiter und der parasitären Kapazität der Fassung zwischen dem ersten (B) und dem dritten (C) Anschlußleiter den Wert K hat.

5. Schaltungsanordnung nach Anspruch 3 oder 4, mit einer Printplatte, in die die integrierte Halbleiterschaltung eingesetzt ist, dadurch gekennzeichnet, daß der Quotient

$$\left(\frac{C_{PBA}}{C_{PCB}}\right)$$

der gegenseitigen Kapazität ($C_{FBA}$) der Leiterbahnen der Printplatte, die mit dem ersten (B) und dem zweiten (A) Anschlußleiter verbunden sind und der gegenseitigen Kapazität ($C_{FCB}$) der Leiterbahnen der Printplatte, die mit dem ersten (B) und dem dritten (C) Anschlußleiter der Printplatte verbunden sind, den Wert K hat.

6. Schaltungsanordnung nach einem der vorangehenden Ansprüche, mit einer Oszillatorschaltung, dadurch gekennzeichnet, daß die Oszillatorschaltung bis auf einen frequenzbestimmenden Schwingkreis in der Halbleiterschaltung integriert ist und der frequenzbestimmende Schwingkreis ($C_0$, $L_0$) zwischen dem ersten (B) und dem zweiten (A) Anschlußleiter angeschlossen ist.

## Claims

1. A circuit arrangement comprising an integrated semiconductor circuit, which circuit comprises a casing with a plurality of connection leads, stray capacitances with equal temperature coefficients existing between a first connection lead and the two adjacent, second and third, connection leads, a voltage being present between the first and the second connection lead which produces a current through the stray capacitance between said connection leads, characterized in that between the first (B) and the third (C) connection lead a voltage is applied which causes a current to flow through the stray capacitance between the first (B) and the third (C) connection leads, which current is equal and opposite to the current through the stray capacitance between the first (B) and second (A) connection lead.

2. A circuit arrangement as claimed in Claim 1, characterized in that the compensation voltage is generated by a circuit which is integrated in the semiconductor circuit.

3. A circuit arrangement as claimed in Claim 1 or 2, characterized in that the amplitude of the compensation voltage ($U_{CB}$) is K times the amplitude of the voltage ($U_{BA}$) between the first (B) and second (A) connection leads, K being the value of the quotient

$$\left(\frac{C_{BA}}{C_{CB}}\right)$$

of the stray capacitance ($C_{BA}$) between the first (B) and second (A) connection leads and the stray capacitance ($C_{CB}$) between the first (B) and third (C) connection leads.

4. A circuit arrangement as claimed in Claim 3, comprising a holder for the integrated semiconductor circuit, characterized in that the quotient

$$\left(\frac{C_{FBA}}{C_{FCB}}\right)$$

of the stray capacitance of the holder between the first (B) and second (A) connection leads and the stray capacitance of the holder between the first (B) and third (C) connection leads has the value K.

5. A circuit arrangement as claimed in Claim 3 or 4, comprising a printed circuit board on which the integrated semiconductor circuit is mounted, characterized in that the quotient

# 0 066 334

$$\left(\frac{C_{PBA}}{C_{PCB}}\right)$$

of the mutual capacitance ($C_{FBA}$) of the conductor tracks of the printed circuit board which are connected to the first (B) and second (A) connection leads and the mutual capacitance ($C_{FCB}$) of the conductor tracks of the printed board which are connected to the first (B) and third (C) connection leads has the value K.

6. A circuit arrangement as claimed in any of the preceding Claims, comprising an oscillator circuit, characterized in that the oscillator circuit, except for a frequency-determining resonant circuit, is integrated in the semiconductor and the frequency-determining resonant circuit ($C_0$, $L_0$) is connected between the first (B) and second (A) connection leads.


**Revendications**

1. Arrangement de circuit comportant un circuit semiconducteur intégré muni d'une enveloppe avec une pluralité de lignes de connexion, dans lequel des capacités parasites à coefficients de température égaux existent entre une première ligne de connexion et les deuxième et troisième lignes de connexion voisines de la première et qu'entre les première et deuxième lignes de connexion est présente une tension et a pour effet un courant à travers la capacité parasite entre ces lignes de connexion, caractérisé en ce qu'une tension de compensation est appliquée entre les première (B) et troisième (C) lignes de connexion, tension qui a pour effet un courant qui circule à travers la capacité parasite entre les première (B) et troisième (C) lignes de connexion et qui est égal, mais opposé, au courant traversant la capacité parasite entre les première (B) et deuxième (A) lignes de connexion.

2. Arrangement de circuit selon la revendication 1, caractérisé en ce que la tension de compensation est obtenue à l'aide d'un circuit intégré dans le circuit semiconducteur.

3. Arrangement de circuit selon la revendication 1 ou 2, caractérisé en ce que l'amplitude de la tension de compensation ($U_{CB}$) est égale à K-fois l'amplitude de la tension ($U_{BA}$) présente entre les première (B) et deuxième (A) lignes de connexion, K étant la valeur du quotient

$$\left(\frac{C_{BA}}{C_{CB}}\right)$$

de la capacité parasite ($C_{BA}$) entre les première (B) et deuxième (A) lignes de connexion et la capacité ($C_{CB}$) entre les première (B) et troisième (C) lignes de connexion.

4. Arrangement de circuit selon la revendication 3, présentant un support pour le circuit semiconducteur intégré, caractérisé en ce que le quotient

$$\left(\frac{C_{FBA}}{C_{FCB}}\right)$$

de la capacité parasite du support entre les première et deuxième lignes de connexion (B) et (A) et la capacité parasite du support entre les première et troisième lignes de connexion (B) et (C) présente la valeur K.

5. Arrangement de circuit selon la revendication 3 ou 4 présentant une plaque à câblage imprimé dans laquelle est monté le circuit semiconducteur intégré, caractérisé en ce que le quotient

$$\left(\frac{C_{PBA}}{C_{PCB}}\right)$$

de la capacité mutuelle ($C_{FBA}$) des trajets de conduction de la plaque à câblage imprimé, qui est connecté aux première (B) et deuxième (A) lignes de connexion et la capacité mutuelle ($C_{FCB}$) des trajets de conduction de la plaque à câblage imprimé, qui est connecté aux première et troisième lignes de connexion (B) et (C) de la plaque à câblage imprimé, présente la valeur K.

6. Arrangement de circuit selon l'une des revendications précédentes, présentant un circuit oscillateur, caractérisé en ce que le circuit oscillateur est intégré, abstraction faite d'un circuit de résonance déterminant la fréquence, dans le circuit semiconducteur et le circuit de résonance déterminant la fréquence ($C_0$, $L_0$) est connecté entre les première (B) et deuxième (A) lignes de connexion.

6

**FIG.1**

$$C_{BA} = C_1 + C_2 \qquad C_{CB} = C_3 + C_4$$

**FIG.2**

**FIG.3**

FIG.4